# EUROPEAN PATENT SPECIFICATION

(11) **EP 3 177 125 B1**
(45) Date of publication and mention of the grant of the patent: **11.12.2019**
(21) Application number: 16193324.7
(22) Date of filing: 11.10.2016
(51) Int. Cl.: H05K 7/20

(54) **A HYBRID COOLING DEVICE**
HYBRIDKÜHLVORRICHTUNG
DISPOSITIF DE REFROIDISSEMENT HYBRIDE

(30) Priority: 01.12.2015 TR 201515215
(43) Date of publication of application: 07.06.2017
(73) Proprietor: Aselsan Elektronik Sanayi ve Ticaret Anonim Sirketi, 06370 Ankara (TR)
(72) Inventor: BALIKCI, CAGRI, 06830 ANKARA (TR); ALAKOC, UGUR, 06370 ANKARA (TR)
(74) Representative: Yamankaradeniz, Kemal

(56) References cited:
- US-A1- 2006 126 296
- US-A1- 2010 103 620
- US-A1- 2013 139 998

## Description

### Field of the Invention

The present invention relates to a hybrid cooling device which enables to cool the electronic modules/cards having high heat discharge by using cooling methods such as two phase spray cooling, immersion cooling and single phase channel liquid cooling methods.

### Background of the Invention

Today, cold plates are used for cooling the device enclosures wherein the electronic modules are located together. The modules are mounted on the cold plates and the heat released from the modules is transferred to the cold plate via conduction. The liquid flowing through the channels of the cold plate convect the heat dissipated from the modules and transfer the heat to the cooling unit. The liquid channels are produced such that they will be constructed of many channels next to each other in mini or micro scale in order to increase the heat transfer in cooling channels.

The United States patent document no. US20080007913A1, an application in the state of the art, discloses an enclosure for cooling electronic cards. A coolant flows through the walls of the enclosure in order to cool the cards in the said enclosure.

In the current spray cooling applications, which is another method for cooling electronic cards, electronic cards located in a closed volume are cooled by being wetted in fog generated by a plurality of nozzles. Similarly, in the immersion cooling method, the electronic cards are cooled by being completely immersed into a dielectric liquid.

After the coolant enters into the electronic unit, it is distributed to every cold plate inside the unit via a liquid distribution manifold. While flowing inside the cold plate, the coolant receives the heat released in electronic modules and then exits the unit by being collected in the accumulation manifold to which the cold plates are connected. The cooling structures used in this cooling method complicate design and production of the device, and cause use of liquid couplings twice as much as the number of the cold plates in the unit. This case also brings maintenance and repair necessity for cooling components as well as electronic members in the unit, decreases the reliability and the lifetime of the unit.

These systems cooled by means of spray or immersion cooling have a complex structure. Large volume condenser structures and heat exchangers should be designed for converting vaporized liquid into liquid phase again in a system designed by using a large amount of nozzles and dielectric liquid. For this reason, the design and production of the system is difficult. The weight and volume requirements of the system are also high.

United States Patent Document no US5907473A, an application known in the state of the art, discloses a spray cooling box and method for cooling at least one electronic card. The said box has a closed section isolating the electronic card from the outer environment. A dielectric heat transfer liquid is stored in this section, and it is sprayed on the electronic cards with a spraying system. Furthermore, a closed cycle condensing system contacts the electronic card, and it is used for condensing the vaporized heat transfer liquid. In the said condensing system, there is an external heat exchanger and two fans, one on the top and the other on the bottom, for cooling the said heat exchanger.

United States Patent Document no US7724524 B1, an application known in the state of the art, discloses a hybrid immersion cooling system for cooling the electronic components. Electronic components are divided as primary and secondary heat generating components, and placed into sealed box. Primary heat generating components are cooled with indirect liquid cooling by using cold plates having fins. Secondary heat generating components are cooled with immersion cooling.

The United States patent document no. US20140124174 discloses a hybrid cooling system. A cooler distribution unit comprises a tank, a heat exchanger, a pump, water inlet and outlet pipes, and it sends liquid for cooling the electronic racks, and receives these heated liquids back for cooling them. The electric components are cooled with immersion cooling via the dielectric coolant. A liquid cooled "heat sink" has a liquid cooled plate; a coolant passes through the said liquid. One or more than one pumps direct the dielectric liquid to sub-cooling areas or liquid cooled heat sink, there is a nozzle on the pump outlet tube and it sprays the pressurized liquid to sub-cooling areas or liquid cooled heat sink.

United States Patent Document no US7911782B2, an application known in the state of the art, discloses a liquid immersion cooling system for cooling a plurality of electronic devices. The said electric device comprises a body, an inner cavity inside the body, a dielectric coolant present in the said inner cavity, heat generating electronic modules attached to the inner cavity and immersed into the dielectric coolant, and a pump for pumping the dielectric liquid into the inner cavity and the heat exchanger mounted outside the body. The said heat exchanger comprises a coolant inlet, outlet and a flow path along the said inlet and outlet. There is also a fan for cooling the heat exchanger.

United States Patent Document no US2010103620 A1 discloses a method and an apparatus for cooling of an electronic system. The apparatus comprises a liquid tight enclosure for providing immersion cooling of electronic systems having an open flow cold plate with a coolant conduit, said coolant conduit enabled for supplying coolants to said cold plate. Said cold plate has at least one orifice on a bottom surface of said cold plate and at least one port on a side surface of said cold plate such that when coolant is supplied to said cold plate, coolant can flow out of said cold plate through said side port(s) and bottom orifice(s) to provide immersion cooling through coolant effluent flow emanating from said cold plate to any to be cooled electronic component(s) disposed in said enclosure.

United States Patent Document no US20130139998 A1 discloses a cooling system comprising a first cooling part and a second cooling part. The first cooling part is adapted to cool a connecting part of a heating element with a first coolant having an electrical insulating property, wherein the connecting part provides electrical connection between the heating element and a board. The second cooling part is adapted to cool another part of the heating element with a second coolant.

United States Patent Document no US20060126296 A1 discloses a cooling apparatus for an electronics assembly comprising a substrate and at least one heat generating electronics device. The cooling apparatus comprises; an enclosure having a perimeter region for sealably engaging the substrate to form a cavity, the at least one heat generating electronics device being disposed within the cavity defined by the substrate and the enclosure. The cooling apparatus further comprises a heat exchange assembly disposed within the enclosure, the heat exchange assembly defining a primary coolant flow path and a separate, secondary coolant flow path, wherein the primary coolant flow path comprises a first chamber and a second chamber, the first chamber and the second chamber being in fluid communication, and wherein the secondary coolant flow path comprises a third chamber disposed between the first chamber and the second chamber of the primary coolant flow path, and wherein the heat exchange assembly provides a first thermal conduction path between primary coolant in the first chamber of the primary coolant flow path and secondary coolant in the third chamber of the secondary coolant flow path, and a second thermal conduction path between primary coolant in the second chamber of the primary coolant flow path and secondary coolant in the third chamber of the secondary coolant flow path. The heat exchange assembly further comprises at least one coolant nozzle associated with the first chamber of the primary coolant flow path, the at least one coolant nozzle directing primary coolant towards a surface of the at least one heat generating electronics device.

### The Problems Solved with the Invention

The objective of the present invention is to provide a hybrid cooling device which enables the electronic cards to be cooled in a both liquid and dry environment in the same system by using spray cooling, immersion cooling and channel cooling techniques under a single thermal management system. The invention is defined by the features of claim 1. Further embodiments are defined in the dependent claims.

In the present invention, the hybrid cooling device integrates the advantages of single phase and two phase flow, atomization and immersion techniques in a single system, it eliminates the need for complex, heavy and large volume structures encountered in spray cooling or immersion cooling the whole system, and it offers an optimized and integrated solution for cooling the system which classifies the system according to heat flow. Therefore, the system can be designed to be lighter and to be smaller in volume integrally. The present invention also enables the system to be more easily producible and less cost costly since less cooling components are used.

Another objective of the present invention is to provide a hybrid cooling device which allows modular cooling technique depending on the heat load. The homogenous heat loads the heat flow of which is up to nearly 50 W/cm² are cooled in the system with channel cooling system. The heat loads from 50 W/cm² to 100 W/cm² which cannot be cooled with channel cooling, but do not require spray cooling can be cooled with immersion cooling technique. The hot points between 100 W/cm² to 150 W/cm²'ye in the electronic system are effectively cooled by being wetted with the spray which is formed.

Since dielectric liquid is used in the inventive hybrid cooling device, the electronic modules are in contact with the liquid. The possibility of failure of the electronic modules is eliminated in case there is liquid leakage as it is in systems using conductive liquid.

The inventive hybrid cooling device eliminates the need for liquid connections in the device, manifold structures used for liquid distribution and collection lines. Cooling structure is comprised of less mechanic parts relative to the current liquid cooling embodiments. Electronic modules remain in a closed and sealed case and are protected from wearing effect of the environmental conditions. The gains obtained with the invention allows to produce more durable devices resistant to military environment conditions, and therefore the performance, credibility, and life of the electronic devices increase.

### Detailed Description of the Invention

A hybrid cooling device developed to fulfill the objectives of the present invention is illustrated in the accompanying figures, in which:

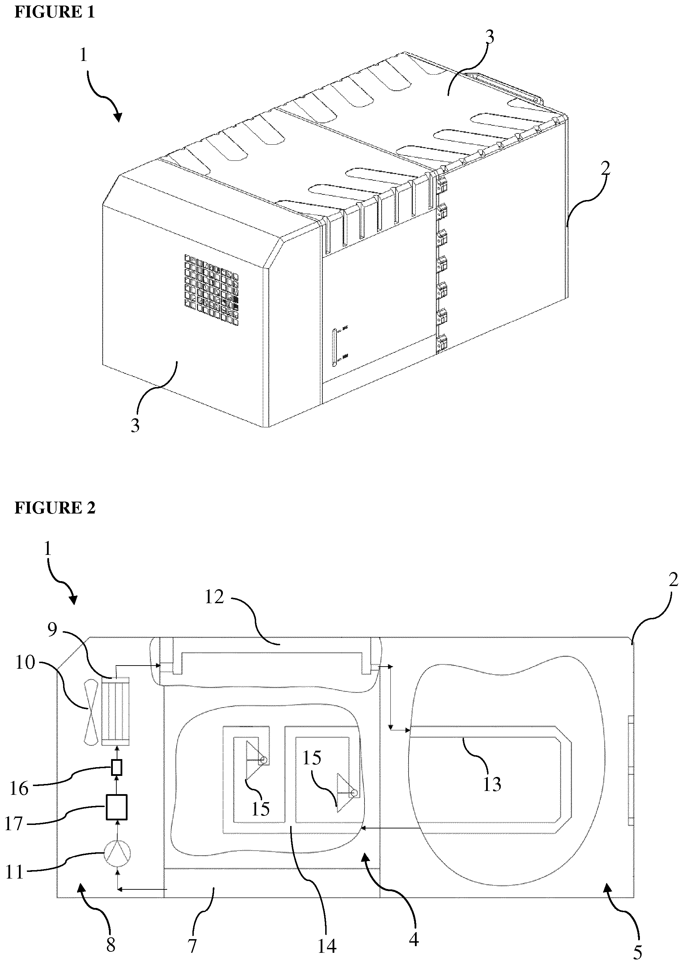

Figure 1 is the perspective view of the enclosure of the hybrid cooling device.
Figure 2 is the schematic view of the hybrid cooling device.

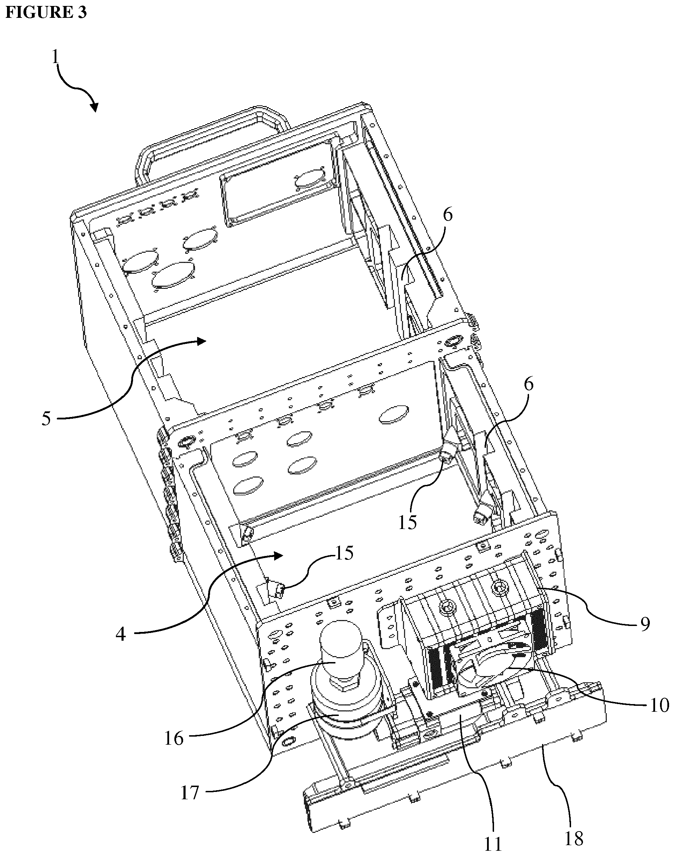

Figure 3 is the perspective view of the hybrid cooling device from another angle.

The components shown in the figures are each given reference numbers as follows:
**1.** Hybrid cooling device
**2.** Enclosure
**3.** Cover
**4.** Spray/immersion section
**5.** Dry cooling section
**6.** Slot
**7.** Reservoir
**8.** Heat discharge section
**9.** Heat exchanger
**10.** Fan
**11.** Pump
**12.** Condenser
**13.** Liquid channel
**14.** Spray/immersion channel
**15.** Nozzle
**16.** Sensor
**17.** Filter
**18.** Control unit

A hybrid cooling device (1), which enables to cool the electronic cards by using dry and liquid cooling techniques under a single thermal management system, essentially comprises
- an enclosure (2) which has at least two separate sections,
   ▪ at least one spray/immersion section wherein the liquid cooling process is realized in the enclosure (2),
   ▪ at least one dry cooling section (5) which is isolated from the spray/immersion section (4) and in which the dry cooling process is realized in the enclosure (2),
- a plurality of slots (6) which are provided inside the spray/immersion section (4) and the dry cooling section (5) and which enables the electronic modules to be fixed,
- at least one reservoir (7) which is provided inside the enclosure (2) and enables the dielectric liquid to be stored therein,
- at least one heat discharge section (8) which is provided outside the spray/immersion section (4), in which the water in the reservoir (7) is cooled via a heat exchanger (9) and a fan (10),
- at least one pump (11) which enables the water in the reservoir (7) to be transferred to the heat discharge section (8) for cooling,
- at least one condenser (12) which is connected to the outlet of the heat exchanger (9), which enables the liquid vaporized in the spray/immersion section (4) to be converted into liquid phase again, and which has serpentine flow pattern,
- at least one liquid channel (13) which passes above at least one of the side walls in the dry cooling section (5), through which the liquid passes for cooling the slots (6) into which the electronic cards are inserted,
- at least one spray/immersion channel (14) which is connected to the outlet of the liquid channel (13), and which enables the liquid in the liquid channels (13) to be transferred to the spray/immersion section (4),
- at least one nozzle (15) which is provided at one end of the spray/immersion channel (14), and which enables the liquid to be atomized and then to be sprayed onto the electronic components.

In a preferred example of the hybrid cooling device (1), there is an enclosure (2), and covers (3) under and above the said enclosure (2) which cut the contact of the electronic modules/cards with the outer environment and provide sealing.

The inner part of the enclosure (2) is formed of two different sections, being dry cooling section (5) and spray/immersion section (4) for cooling the electronic modules in dry and liquid medium. The number of the said sections is not limited to two; it can be increased depending on the preference. On the outer part of the enclosure (2), preferably on the rear wall there is a heat discharge section (8) for cooling the coolant (dielectric liquid).

In the heat discharge section (8), there are a control unit (18), a pump (119, a heat exchanger (9), at least one fan (10), sensor (16), and filter (17). In the spray/immersion section (4), there are slot (6), condenser (12), spray/immersion channel (14), nozzle (15), and reservoir (7). In the dry cooling section (5), there are slots (6), and liquid channels (13) which cool the said slots (6) heated via conduction by the electronic modules by contacting the said slots (6). The said liquid channels (13) can also be designed as a single liquid channel (13) which surrounds the walls of the dry cooling section (5), as well as they can be provided on each side wall separately.

The conduction cooling electronic modules are attached to the slots (6) fixed to the walls of the dry cooling section (5) and spray/immersion section (4). In order to perform direct wet cooling on the electronic modules with high heat discharge in the spray/immersion section (4), the said cards can be attached to their slots (6) in the section by being uncovered such that the electronic components thereon will be seen, as well as they can be attached by being packed in a completely hermetic structure in order to perform indirect dry cooling in the dry cooling section (5).

An amount of dielectric cooling liquid used for cooling the electronic modules in the enclosure (2) is already stored in the reservoir (7) located under the spray/immersion section (4). The cooling liquid transferred to the heat discharge section (8) wherein thermal control is performed from the reservoir (7) via the pump (11) is cooled by means of the heat exchanger (9) and the fan (10) located in the heat discharge section (8). The said cooling process performed in heat discharge section (8) is explained in the following paragraphs.

There are two corresponding condensers (12) connected to the outlet of the heat exchanger (9), on the roof of the spray/immersion section (4), extending towards the dry cooling section (5) parallel to the ground plane, having serpentine flow pattern. The liquid cooled in the heat exchanger (9) located in the heat discharge section (8) enters into the inlet of each one of the condensers (12) from the outlet of the said heat exchanger (9) through separate channels. In another example, there is a single condenser (12) on the roof of the spray/immersion section (4), the liquid cooled in the heat exchanger (9) located in the heat discharge section (8) enters through a single channel provided at the inlet of the said condenser (12), and it moves towards the dry cooling section (5) with serpentine flow pattern along the condenser (12). The number of the condensers (12) is not fixed, it can be decreased or increased as desired.

The condenser (12) enables the liquid, which is vaporized when sprayed into the electronic modules via the nozzles (15) in the spray/immersion section (4), to be converted into liquid phase again (the part about vaporization will be explained in detail). Then the liquid flowing through the condensers (12) enters into the dry cooling section (5) through two channels, and moves along the two liquid channels (13) fixed onto the side walls of the dry cooling section (5). In another example, when there is a single condenser (12) provided in the enclosure (2), the said liquid moves from a single outlet of the condenser (12) to a single liquid channel (13) fixed to the side walls of the dry cooling section (5). In another example, the outlet of a single condenser (12) is multiplexed with a T connection, and thus the liquid inside the said condenser (12) can move into the two liquid channels (13) fixed to two side walls of the dry cooling section (5).

Two separate liquid channels (13) fixed to the side walls in the dry cooling section (5) contact all or some part of the slots (6) extending vertical to the ground plane. In a preferred example, the liquid channels (13) have U shaped geometry such that they will contact the slots (6) from two points (from top and bottom). By means of the U geometry of the liquid channel (13), the liquid channel (13) goes by contacting the upper part of the slots (6), it is bent after passing the slots (6), and it moves such that will contact the lower part of the same slots (6) and returns back to the spray/immersion section (4). Therefore, with the contact made with the slots (6) from two points, it is enabled that the slots (6) are cooled more effectively. The geometry of the said liquid channels (13) may be designed in different patterns (for example in serpentine pattern) in order to increase contact point with the slots (6). The number of contact points of the liquid channels (13) is not fixed; this number can be decreased or increased depending on the geometry of the liquid channel (13). In another example, a single liquid channel (13) is used, and the said liquid channel (13) travels around the walls of the dry cooling section (5), and contacts all slots (6) from at least one point.

The heat generated by the conduction cooled electronic modules attached to the slots (6) provided in the dry cooling section (5) is transferred to the said slots (6) via conduction. The liquid inside the liquid channels (13) on the walls of the dry cooling section (5) flows in a single phase through the said channels (13), it cools the slots (6), and thus the electronic modules. Then, the liquid flowing through the liquid channels (13) enters into the spray/immersion section (4) from two channels, and it completes the flow in two spray/immersion channels (14) having the same length, and it is atomized in the nozzles (15) within the spray/immersion section (4). In one example, in case there is a single liquid channel (13), the liquid flowing through the liquid channel (13) enters into the spray/immersion channel (14) from a single channel in the spray/immersion section (4), and it completes the flow in the spray/immersion channel (14) and it is atomized in the nozzles (15) in the spray/immersion section (4).

At the end of the spray/immersion channels (14) in the spray/immersion section (4), there are nozzles (15) which enable the liquid to be atomized. The nozzles (15) are directed towards the components with highest temperature flux located on the electronic modules for an effective cooling. The spray angle can be optimized such that it will include the largest surface of the module. The sprayed liquid is vaporized after contacting the heat discharging components and it is transformed into two phase flow. The liquid phase, which is one of these two phases, is collected in the reservoir (7) provided under the spray/immersion section (4) with the effect of the weight. The vaporized liquid is converted into liquid phase in the condenser (12) and flows into the spray/immersion section (4), and it is collected in the reservoir (7).

There are two more separate examples of the inventive hybrid cooling device (1) apart from the dry-spray cooling. These are dry-immersion and dry-spray/immersion cooling examples. The said examples are explained below in turn.

In dry-immersion cooling application, which is an alternative example, one end of one of the channels is connected to the outlet of the liquid channel (13), and the other end directly opens to the spray/immersion section (4) (not shown in figures). The liquid exiting from the liquid channels (13) fills the spray/immersion section (4) with liquid to a line at which the electronic modules will be completely under liquid. All surfaces of the electronic module are in contact with the liquid since immersion is performed. The dielectric liquid is vaporized after contacting the heat discharging components and it is transformed into two phase flow. The vaporized liquid is converted into liquid phase again the condenser (12) and then it flows into the spray/immersion section (4).

In dry-spray/immersion cooling application, which is another alternative example, the spray/immersion section (4) is divided into two separate sections, namely spray section and immersion section (not shown in the figures). In the spray section, there are a plurality of slots (6), condenser (12), spray/immersion channel (14), nozzle (15), and reservoir (7). In the immersion section, there are slot (6), condenser (12), spray/immersion channel (14), nozzle (15), and reservoir (7). The reservoir (7) and the condenser (12) under the said sections can be designed as single piece such that it can be used by both sections. In this alternative example, the liquid coming from the liquid channel (13) in the dry cooling section (5) is transferred to the spray/immersion channels (14) in the spray section and the immersion section through two separate channels, and it can be used both as spray cooling and immersion cooling separately in these sections. The liquid transferred to the spray/immersion channels (14) in the spray section through the liquid channel (13) is sprayed onto the electronic modules via the nozzles (15), it vaporizes with the effect of the temperature in these modules, and it is converted into liquid phase in the condenser (12), and it is collected in the reservoir (7) under this spray section. The liquid transferred to the spray/immersion channels (14) in the immersion section from the liquid channel (13) fills the immersion section, and the electronic modules are cooled in this liquid. The said liquid vaporized with the effect of the temperature is converted into liquid phase again in the condenser (12).

The explanations from this point on are common for three abovementioned applications (dry-spray cooling, dry-immersion cooling, dry-spray/immersion cooling). In the spray/immersion section (4), the dielectric liquid collected in the spray section or the immersion section flows into a pump (11) suction channel provided under these sections/compartments, and passes to the heat discharge section (8) in which the thermal control is performed. The liquid pressurized in the pump (11) is filtered by being passed through a filter (17). The pressure and/or temperature of the liquid is measured with a sensor (16) provided at the outlet of the filter (17), and it is transferred to the control unit (18). Then, the liquid passes through micro/mini channel heat exchanger (9) on which the fan (10) is attached, and thus the liquid is enabled to be cooled. In order to produce a compact heat exchanger (9), the channels therein can be manufactured from mini and micro channels. Therefore, efficient cooling is performed in a small volume. A liquid hose at the outlet of the heat exchanger (9) is divided into two with a T connection, and it is enabled that the liquid enters into the condenser (12) from two channels.

There is a control unit (18) in the heat discharge section (8). The said control unit (18) controls the liquid pressure and temperature in the sensor (16), adjusts the cycle of the fan (10) and the pump (11), and enables the heat control to be performed. Furthermore, the control unit (18) makes audio (buzzer) or visual (LCD screen or color Led) notification when a failure occurs by carrying out an in-device test function, it cuts the power of the unit at low and high temperature limits, and thus it ensures the safety of the components in the hybrid cooling device (1).

The production method of the hybrid cooling device (1) allowing three dimensional single phase and two-phase flow is vacuum brazing. The mechanic parts forming the walls of the device are connected with the liquid channels (13) and the spray/immersion channels (14) by means of brazing in a single step. The details on the walls are made with mechanic machining after brazing, and the production is finished.

## Claims

1. A hybrid cooling device (1) for cooling the electronic cards by using dry and liquid cooling techniques under a single thermal management system, the hybrid cooling device (1) **comprising**
- an enclosure (2) which has at least three separate sections,
▪ at least one spray/immersion section (4) which is divided into two sections, being spray section and immersion section, and in which the liquid cooling process in the enclosure (2) is realized,
▪ at least one dry cooling section (5) which is isolated from the spray/immersion section (4) and in which the dry cooling process is realized in the enclosure (2),
- a plurality of slots (6) which are provided inside the spray/immersion section (4) and the dry cooling section (5) and adapted to fix the electronic modules,
- at least one reservoir (7) provided inside the enclosure (2) for storing the dielectric liquid therein,
- at least one heat discharge section (8) which is provided outside the spray/immersion section (4), in which the water in the reservoir (7) is cooled via a heat exchanger (9) and a fan (10),
- at least one pump (11) adapted to transfer the water in the reservoir (7) to the heat discharge section (8) for cooling,
- at least one condenser (12) which is connected to the outlet of the heat exchanger (9) and adapted to convert the liquid vaporized in the spray/immersion section (4) into liquid phase again,
- at least two spray/immersion channels (14) one of which is provided in the spray section, connected to the outlet of the one of the liquid channels (13) and adapted to transfer the liquid in the liquid channels (13) to the spray/immersion section (4), and the other one of which is provided in the immersion section, one end of which is connected to the outlet of the other liquid channel (13) and the other end of which is adapted to open to the spray/immersion section (4) of the liquid and which is adapted to fill the liquid in the liquid channels (13) into the spray/immersion section (4),
- at least one nozzle (15) which is provided at the end of the spray/immersion channel (14) in the spray section of the spray/immersion section (4), and adapted to atomize the liquid and then to spray the liquid onto the electronic components, **and characterized by**
- at least two liquid channels (13) which are adapted to pass on at least one of the sidewalls in the dry cooling section (5), through which the liquid passes for cooling the slots (6) into which the electronic cards are attached, and which are adapted to transfer the said liquid to the spray/immersion liquids (14) in the spray section and the immersion section.

2. The hybrid cooling device (1) according to claim 1, **characterized by** at least one filter (17) adapted to filter the liquid pressurized in the pump (11).

3. The hybrid cooling device (1) according to claim 2, **characterized by** at least one sensor (16) which is provided at the filter (17) outlet, and adapted to measure the pressure and/or temperature of the liquid.

4. The hybrid cooling device (1) according to claim 1, **characterized by** covers (3) adapted to cut the contact of the electronic modules with the outer environment under and/or above the enclosure (2) for sealing.

5. The hybrid cooling device (1) according claim 3, **characterized by** control unit (18) which is adapted to control the liquid pressure and temperature from the sensor (16), and to perform thermal control by adjusting the cycle of the pump (11).

6. The hybrid cooling device (1) according to claim 5, **characterized by** control unit (18) which is adapted to cut the power of the unit at high and low temperature limits by performing a test function for a device.

7. The hybrid cooling device (1) according to claim 6, **characterized by** control unit (18) which is adapted to make audio or visual notification in case of a failure.

8. The hybrid cooling device (1) according to claim 1, **characterized by** condenser (12) which is connected to the outlet of the heat exchanger (9), which is adapted to extend towards the dry cooling section (5) in a way parallel way to ground plane on the roof of the spray/immersion section (4), which has serpentine flow pattern.

9. The hybrid cooling device (1) according to claim 1, **characterized by** reservoir (7) which is provided under the spray/immersion section (4), in which the vaporized liquid converted into liquid phase via the condenser (12) is collected.

10. The hybrid cooling device (1) according to claim 1, **characterized by** liquid channel (13) adapted to contact all slots (6) from at least one point by travelling around the walls of the dry cooling section (5).

11. The hybrid cooling device (1) according to claim 1, **characterized by** liquid channel (13) having U shaped geometry such that it will contact the slots (6) from two points preferably top and lower points.

12. The hybrid cooling device (1) according to claim 1, **characterized by** liquid channel (13) which is fixed to the side walls in the dry cooling section (5), and adapted to contact all slots (6) extending vertical to the ground plane, or some part of them from at least one point.

## Patentansprüche

1. Hybridkühlvorrichtung (1) zum Kühlen der elektronischen Karten durch Verwenden von Trocken- und Flüssigkeitskühltechniken unter einem einzigen Temperaturmanagementsystem, die Hybridkühlvorrichtung (1) umfassend
- ein Gehäuse (2), das mindestens drei separate Abschnitte aufweist,
▪ mindestens einen Sprüh-/Eintauchabschnitt (4), der in zwei Abschnitte unterteilt ist, nämlich Sprühabschnitt und Eintauchabschnitt, und in dem der Flüssigkeitskühlprozess in dem Gehäuse (2) ausgeführt wird,
▪ mindestens einen Trockenkühlabschnitt (5), der von dem Sprüh-/Eintauchabschnitt (4) isoliert ist und in dem der Trockenkühlprozess in dem Gehäuse (2) ausgeführt wird,
- eine Vielzahl von Schlitzen (6), die innerhalb des Sprüh-/Eintauchabschnitts (4) und des Trockenkühlabschnitts (5) bereitgestellt und zum Befestigen der Elektronikmodule angepasst sind,
- mindestens einen Behälter (7), der innerhalb des Gehäuses (2) zum Speichern der dielektrischen Flüssigkeit darin bereitgestellt ist,
- mindestens einen Wärmeableitbereich (8), der außerhalb des Sprüh-/Eintauchabschnitts (4) bereitgestellt ist, in dem das Wasser in dem Behälter (7) über einen Wärmetauscher (9) und einen Lüfter (10) gekühlt wird,
- mindestens eine Pumpe (11), die angepasst ist, um das Wasser in dem Behälter (7) zum Kühlen zu dem Wärmeableitabschnitt (8) zu fördern,
- mindestens einen Kondensator (12), der mit dem Ausgang des Wärmetauschers (9) verbunden ist und angepasst ist, die in dem Sprüh-/Eintauchabschnitt (4) verdampfte Flüssigkeit wieder in flüssige Phase umzuwandeln,
- mindestens zwei Sprüh-/Eintauchkanäle (14), wovon einer in dem Sprühabschnitt bereitgestellt ist, der mit dem Auslass des einen der Flüssigkeitskanäle (13) verbunden und angepasst ist, um die Flüssigkeit in den Flüssigkeitskanälen (13) zu dem Sprüh-/Eintauchabschnitt (4) zu übertragen, und der andere in dem Tauchabschnitt bereitgestellt ist, wovon ein Ende mit dem Auslass des anderen Flüssigkeitskanals (13) verbunden ist, und wovon das andere Ende angepasst ist, um den Sprüh-/Eintauchabschnitt (4) der Flüssigkeit zu öffnen und der angepasst ist, die Flüssigkeit in den Flüssigkeitskanälen (13) in den Sprüh-/Eintauchabschnitt (4) zu füllen,
- mindestens eine Düse (15), die an dem Ende des Sprüh-/Eintauchkanals (14) in dem Sprühabschnitt des Sprüh-/Eintauchabschnitts (4) bereitgestellt ist und die angepasst ist, um die Flüssigkeit zu zerstäuben und die Flüssigkeit dann auf die elektronischen Komponenten zu sprühen, und **dadurch gekennzeichnet, dass**
- mindestens zwei Flüssigkeitskanäle (13), die angepasst sind, um an mindestens einer der Seitenwände in dem Trockenkühlabschnitt (5) zu verlaufen, durch die die Flüssigkeit zum Kühlen der Schlitze (6) strömt, in die die elektronischen Karten eingesetzt sind, und die angepasst sind, um die Flüssigkeit zu den Spritz-/Eintauchflüssigkeiten (14) in dem Sprühabschnitt und in dem Eintauchabschnitt zu übertragen.

2. Hybridkühlvorrichtung (1) nach Anspruch 1, **gekennzeichnet durch** mindestens einen Filter (17), der angepasst ist, um die in der Pumpe (11) unter Druck gesetzte Flüssigkeit zu filtern.

3. Hybridkühlvorrichtung (1) nach Anspruch 2, **gekennzeichnet durch** mindestens einen Sensor (16), der an dem Ausgang des Filters (17) bereitgestellt und zum Messen des Drucks und/oder der Temperatur der Flüssigkeit angepasst ist.

4. Hybridkühlvorrichtung (1) nach Anspruch 1, **gekennzeichnet durch** Abdeckungen (3), die angepasst sind, um den Kontakt der elektronischen Module mit der äußeren Umgebung unter und/oder über dem Gehäuse (2) zum Abdichten zu unterbrechen.

5. Hybridkühlvorrichtung (1) nach Anspruch 3, **gekennzeichnet durch** eine Steuereinheit (18), die angepasst ist, um den Druck und die Temperatur der Flüssigkeit von dem Sensor (16) zu steuern und eine thermische Steuerung durch Einstellen des Zyklus der Pumpe (11) auszuführen.

6. Hybridkühlvorrichtung (1) nach Anspruch 5, **gekennzeichnet durch** eine Steuereinheit (18), die angepasst ist, um die Leistung der Einheit an Hoch- und Tieftemperaturgrenzen durch Ausführen einer Testfunktion für eine Vorrichtung zu unterbrechen.

7. Hybride Kühlvorrichtung (1) nach Anspruch 6, **gekennzeichnet durch** eine Steuereinheit (18), die geeignet ist, im Fall eines Fehlers eine akustische oder optische Benachrichtigung vorzunehmen.

8. Hybridkühlvorrichtung (1) nach Anspruch 1, **gekennzeichnet durch** einen Kondensator (12), der mit dem Auslass des Wärmetauschers (9) verbunden ist, der angepasst ist, um sich auf parallele Weise zur Grundplatte auf dem Dach des Sprüh-/Eintauchabschnitts (4), der ein Serpentinenströmungsmuster aufweist, zu dem Trockenkühlabschnitt (5) zu erstrecken.

9. Hybridkühlvorrichtung (1) nach Anspruch 1, **gekennzeichnet durch** einen Behälter (7), der unter dem Sprüh-/Eintauchabschnitt (4) bereitgestellt ist, in dem die verdampfte Flüssigkeit, die über den Kondensator (12) in flüssige Phase umgewandelt wird, gesammelt wird.

10. Hybrid-Kühlvorrichtung (1) nach Anspruch 1, **gekennzeichnet durch** einen Flüssigkeitskanal (13), der angepasst ist, um alle Schlitze (6) von mindestens einem Punkt aus zu kontaktieren, indem er um die Wände des Trockenkühlabschnitts (5) wandert.

11. Hybridkühlvorrichtung (1) nach Anspruch 1, **gekennzeichnet durch** einen Flüssigkeitskanal (13), der eine U-förmige Geometrie aufweist, sodass er die Schlitze (6) von zwei Punkten, vorzugsweise von oben und unten, berührt.

12. Hybridkühlvorrichtung (1) nach Anspruch 1, **gekennzeichnet durch** einen Flüssigkeitskanal (13), der an den Seitenwänden in dem Trockenkühlabschnitt (5) befestigt und angepasst ist, alle Schlitze (6) zu berühren, die sich von mindestens einem Punkt aus senkrecht zu der Grundplatte oder einem Teil davon erstrecken.

## Revendications

1. Dispositif de refroidissement hybride (1) pour le refroidissement des cartes électroniques en utilisant des techniques de refroidissement à sec et liquides dans le cadre d'un système unique de gestion thermique, le dispositif de refroidissement hybride (1) **comprenant**
- un boîtier (2) comprenant au moins trois sections distinctes,
▪ au moins une section de pulvérisation /immersion (4) subdivisée en deux sections, à savoir une section de pulvérisation et une section d'immersion, et dans laquelle est effectué le procédé de refroidissement par liquide dans le boîtier (2),
▪ au moins une section de refroidissement à sec (5) isolée de la section de pulvérisation /immersion (4), et dans laquelle est effectué le procédé de refroidissement à sec dans le boîtier (2),
- une pluralité de fentes (6) pratiquées à l'intérieur de la section de pulvérisation/immersion (4) et la section de refroidissement à sec (5), et adaptées pour fixer les modules électroniques,
- au moins un réservoir (7) étant placé à l'intérieur du boîtier (2) pour stocker, dans celui-ci, le liquide diélectrique,
- au moins une section de refoulement de la chaleur (8), pratiquée à l'extérieur de la section de pulvérisation /immersion (4), dans laquelle l'eau dans le réservoir (7) est refroidie par le biais d'un échangeur de chaleur (9) et d'un ventilateur (10),
- au moins une pompe (11) adaptée pour transférer, à la section de refoulement de la chaleur (8), l'eau dans le réservoir (7) pour le refroidissement,
- au moins un condenseur (12) connecté à la sortie de l'échangeur de chaleur (9) et adapté pour reconvertir dans sa phase liquide le liquide vaporisé dans la section de pulvérisation /immersion (4),
- au moins deux canaux de pulvérisation/d'immersion (14), un desquels étant pratiqué dans la section de pulvérisation, connecté à la sortie de celui des canaux de liquide (13), et adapté pour transférer le liquide dans les canaux de liquide (13) de la section de pulvérisation /immersion (4), l'autre desquels étant pratiqué dans la section d'immersion, un bout desquels étant connecté à la sortie de l'autre canal de liquide (13), l'autre bout étant adapté pour déboucher dans la section de pulvérisation /immersion (4) du liquide, et étant adapté pour remplir le liquide, situé dans les canaux de liquide (13), dans la section de pulvérisation /immersion (4),
- au moins un embout (15), pratiqué à l'extrémité du canal de pulvérisation/d'immersion (14), dans la section de pulvérisation de la section de pulvérisation/immersion (4), et adapté pour atomiser le liquide, pour pulvériser ensuite le liquide sur les composants électroniques, **et caractérisé par**
- au moins deux canaux de liquide (13) adaptés pour passer sur au moins une des parois latérales dans la section de refroidissement à sec (5), à travers lesquels s'écoule le liquide pour refroidir les fentes (6) dans lesquelles sont fixées les cartes électroniques, et adaptés pour transférer ledit liquide, dans les liquides de pulvérisation /d'immersion (14), dans la section de pulvérisation et la section d'immersion.

2. Dispositif de refroidissement hybride (1) selon la revendication 1, **caractérisé par** au moins un filtre (17) adapté pour filtrer le liquide pressurisé dans la pompe (11).

3. Dispositif de refroidissement hybride (1) selon la revendication 2, **caractérisé par** au moins un capteur (16) placé à la sortie du filtre (17), et adapté pour mesurer la pression et/ou la température du liquide.

4. Dispositif de refroidissement hybride (1) selon la revendication 1, **caractérisé par** des couvercles (3) adaptés pour couper le contact des modules électroniques avec le milieu extérieur au-dessous et/ou au-dessus du boîtier (2) pour une fermeture étanche.

5. Dispositif de refroidissement hybride (1) selon la revendication 3, **caractérisé par** un module de commande (18) adapté pour contrôler la pression et la température du liquide depuis le capteur (16), et effectuer une régulation thermique en ajustant le cycle de la pompe (11).

6. Dispositif de refroidissement hybride (1) selon la revendication 5, **caractérisé par** un module de commande (18) adapté pour couper le courant d'alimentation de l'appareil à des seuils de haute et basse température, en effectuant une fonction d'essai pour un dispositif.

7. Dispositif de refroidissement hybride (1) selon la revendication 6, **caractérisé par** le module de commande (18) adapté pour effectuer une notification visuelle en cas de défaillance.

8. Dispositif de refroidissement hybride (1) selon la revendication 1, **caractérisé par** un condenseur (12) connecté à la sortie de l'échangeur de chaleur (9), adapté pour s'étendre en direction de la section de refroidissement à sec (5) parallèlement à un plan horizontal sur le toit de la section de pulvérisation/immersion (4), présentant un motif d'écoulement en serpentin.

9. Dispositif de refroidissement hybride (1) selon la revendication 1, **caractérisé par** un réservoir (7) pratiqué sous la section de pulvérisation /immersion (4), dans laquelle le liquide vaporisé, converti en phase liquide via le condenseur (12), est recueilli.

10. Dispositif de refroidissement hybride (1) selon la revendication 1, **caractérisé par** un canal de liquide (13) adapté pour être au contact de toutes les fentes (6) depuis au moins un point, en se déplaçant autour des parois de la section de refroidissement à sec (5).

11. Dispositif de refroidissement hybride (1) selon la revendication 1, **caractérisé par** un canal de liquide (13) ayant une géométrie en forme de U afin d'être au contact des fentes (6) depuis deux points, de préférence des points supérieur et inférieur.

12. Dispositif de refroidissement hybride (1) selon la revendication 1, **caractérisé par** un canal de liquide (13) fixé aux parois latérales dans la section de refroidissement à sec (5), et adapté pour être au contact de toutes les fentes (6) s'étendant verticalement au plan horizontal, ou une partie de celles-ci, depuis au moins un point.
